Europäisches Patentamt

European Patent Office

Office européen des brevets

(19)

(11) Numéro de publication: **0 018 264**
**B1**

(12) **FASCICULE DE BREVET EUROPEEN**

(45) Date de publication du fascicule du brevet: **27.06.84**

(21) Numéro de dépôt: **80400452.1**

(22) Date de dépôt: **04.04.80**

(51) Int. Cl.³: **G 02 B 5/16,** G 03 B 41/00,
G 02 B 19/00

(54) Illuminateur à lampe à arc.

(30) Priorité: **23.04.79 FR 7910210**

(43) Date de publication de la demande:
**29.10.80 Bulletin 80/22**

(45) Mention de la délivrance du brevet:
**27.06.84 Bulletin 84/26**

(84) Etats contractants désignés:
**DE GB**

(56) Documents cités:
**DE - A - 2 755 047**
**FR - A - 1 592 854**
**FR - A - 2 412 865**
**US - A - 3 596 083**

(73) Titulaire: **THOMSON-CSF**
**173, Boulevard Haussmann**
**F-75379 Paris Cedex 08 (FR)**

(72) Inventeur: **Lacombat, Michel**
**"THOMSON-CSF" SCPI 173, Bld Haussmann**
**F-75360 Paris Cedex 08 (FR)**
Inventeur: **Dubroeucq, Georges Michel**
**"THOMSON-CSF" SCPI 173, Bld Haussmann**
**F-75360 Paris Cedex 08 (FR)**

(74) Mandataire: **Lepercque, Jean et al,**
**THOMSON-CSF SCPI 173, Bld Haussmann**
**F-75379 Paris Cedex 08 (FR)**

# Description

L'invention se rapporte au domaine du transfert optique de motifs par projection et a plus particulièrement pour objet un illuminateur destiné à un tel transfert optique.

La fabrication de circuits intégrés nécessite pour chaque étape de fabrication d'un niveau du circuit intégré sur le substrat (silicium, Arséniure de Gallium), la réalisation sur ce substrat de fenêtres permettant de localiser l'implantation ou le traitement. Ces fenêtres sont réalisées par masquage d'une couche de résine déposée sur le substrat à partir d'un masque. Antérieurement le masque était placé au contact ou à proximité du substrat pour l'exposition. Cette méthode tend à être remplacée par une méthode de transfert par projection optique, cette projection pouvant être réalisée à un grandissement choisi, le motif pouvant être répété par la technique de photorépétition.

Pour le transfer optique de motifs, il est possible d'utiliser des illuminateurs qui peuvent être par exemple des sources laser ou des lampes à arc à décharge, particulièrement des lampes à vapeur de mercure associées à des filtres convenables pour obtenir un éclairement compatible avec la bande spectrale B souvent très étroite des objectifs de projection (B≠100 nm). La lumière issue de la source éclaire l'objet (c'est à dire le masque) via un condenseur, l'objet étant situé au voisinage du condenseur. D'une manière générale, il a été montré qu'un compromis entre la résolution effective susceptible d'être obtenue et le champ pouvait être obtenu en utilisant une lumière partiellement cohérente spatialement. Le rapport $\sigma$ entre le diamètre de la tache projetée sur la pupille d'entrée du système optique de projection et le diamètre de cette pupille d'entrée constitue une mesure de la cohérence de l'illumination. Lorsque $\sigma=0$, l'illumination est cohérente, $\sigma=\infty$ l'illumination est incohérente et $\sigma=1$, l'illumination est quasi incohérente. Pour les illuminateurs associés à des objectifs de projection classiques, d'ouverture numérique 0.3 et de diamètre 15 mm par exemple, ce compromis se situe actuellement autour de $\sigma=0.7$. Dans de tels illuminateurs, il est tenu compte du rendement énergétique, $\sigma=0.7$ étant une valeur pour laquelle ce rendement est considéré comme convenable. Pour obtenir un tel coefficient $\sigma$, on utilise une source étendue convenablement diaphragmée.

En fait, le calcul montre qu'une amélioration importante d'un certain nombre des paramètres dont dépendent les performances du dispositif de transfert optique, est obtenue avec un coefficient $\sigma=0.3$, c'est à dire avec une illumination plus cohérente spatialement que celle utilisée dans un illuminateur classique où $\sigma$ a été choisi égal à 0.7. En effet, la résolution effective augmente avec la cohérence; la largeur de trait minimale susceptible d'être obtenue diminue lorsque la cohérence de l'illumination augmente; la définition augmente également lorsque la cohérence augmente. De plus les défauts dûs aux variations d'épaisseur de la couche de résine déposée sur une surface déjà profilée, diminuent lorsque la cohérence augmente. Compte tenu de tous ces paramètres, une augmentation de la cohérence de l'illumination est souhaitable pour obtenir des motifs plus précisément contrôlés et plus fins.

Par ailleurs, par exemple, du brevet US—A— 3 596 083, sont connus des illuminateurs du type comportant une lampe à arc servant de source et un faisceau de fibres optiques dont la face de sortie forme source pour une lentille intermédiaire et dont l'image par cette lentille intermédiaire donne lieu à illumination ayant un degré de cohérence spatial donné pour un dispositif optique d'utilisation. Les surfaces d'entrées et sortie du faisceau de fibres optiques sont sensiblement égales. Bien que le contour de la face d'entrée puisse revêtir diverses formes, par exemple celle d'un rectangle, la surface de captation est sensiblement égale ou supérieure à la surface de l'image réelle de la lampe à arc servant de source formée par des éléments optiques dans le plan de la face d'entrée du faisceau de fibres optiques. Il s'ensuit que l'on obtient un degré de cohérence relativement élevé, typiquement égal au coefficient 0.7 rappelé.

Un coefficient inférieur peut être obtenu, c'est à dire une plus grande cohérence, en diaphragmant la source constituée par la face de sortie du faisceau de fibres optiques.

Cependant, il ne faut pas que le rendement énergétique devienne trop faible et que des défauts liés à une trop grande cohérence de l'illumination apparaissent. Ces inconvénients peuvent résulter d'une part d'une limitation excessive du diamètre de la source effective et d'autre part de la plus grande sensibilité du dispositif de transfert aux défauts locaux (et aux poussières), présents sur le réticule et sur l'objectif de projection. Les défauts liés à un grand degré de cohérence, eu égard aux défauts de surface, peuvent être limités en prenant soin de l'objectif de projection.

Quant au rendement énergétique, il peut être maintenu dans un illuminateur choisi avec $\sigma=0.3$ en utilisant au mieux la répartition d'intensité fournie par la source en liaison avec la pupille d'entrée de l'objectif pour que la limitation des dimensions de la source affecte au minimum le rendement énergétique.

L'invention propose un illuminateur comportant une lampe à arc, conçu pour que le rendement énergétique soit maximum compte tenu d'un degré de cohérence spatiale déterminé de l'illumination.

L'invention a donc pour objet un illuminateur comportant une lampe à arc servant de source, un assemblage de lentilles condenseur et de filtres formant dans un plan image de la source une image réelle de la source à partir du rayonnement issu de la lampe à arc, cette image comportant deux zones d'intensité maximum, un faisceau de fibres optiques dont la face d'entrée est placée dans le plan image pour capter le rayonnement dans celui-ci, et dont la face de sortie formant source pour une lentille intermédiaire présente une surface telle que son image par cette lentille intermédiaire donne lieu, pour un dispositif d'utilisation optique déterminé, à une illumination présentant un degré de cohérence spatiale donné au niveau de la pupille d'entrée dudit dispositif d'utilisation optique; la surface totale de la face d'entrée du faisceau de fibres optiques étant sensiblement égale à la surface de sa face de sortie, caractérisé en ce que ledit degré de cohérence spatiale est désiré tel qu'il nécessite le choix, pour la face de sortie du faisceau de fibres optiques, d'une surface inférieure à celle de l'image réelle de ladite source dans le plan image de celle-ci, les fibres optiques du faisceau étant alors assemblées dans la face d'entrée placée dans le plan image en deux faisceaux séparés dont les extrémités sont alignées avec les deux zones d'intensité maximum dans le plan image de la source, de façon à capter le maximum du rayonnement dans ce plan image.

L'invention sera mieux comprise et d'autres caractéristiques apparaîtront à l'aide de la description qui suit en référence aux figures annexées.

La figure 1 represente un illuminateur à lampe à vapeur de mercure de l'art connu, le degré de cohérence de l'illumination étant de $\sigma=0,7$.

Les figures 2a et 2b représentent la répartition d'éclairement respectivement obtenue à l'entrée et à la sortie du faisceau de fibres dans l'illuminateur de la figure 1.

La figure 3 représente un illuminateur selon l'invention où le dégré de cohérence est $\sigma=0.3$.

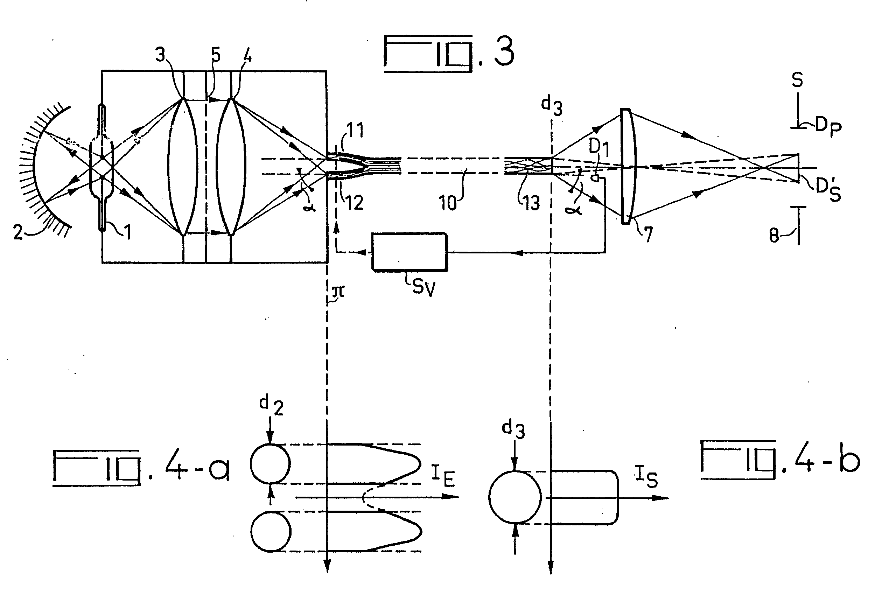

Les figures 4a et 4b représentent la répartition d'éclairement respectivement obtenue à l'entrée et à la sortie du faisceau de fibres dans l'illuminateur de la figure 3.

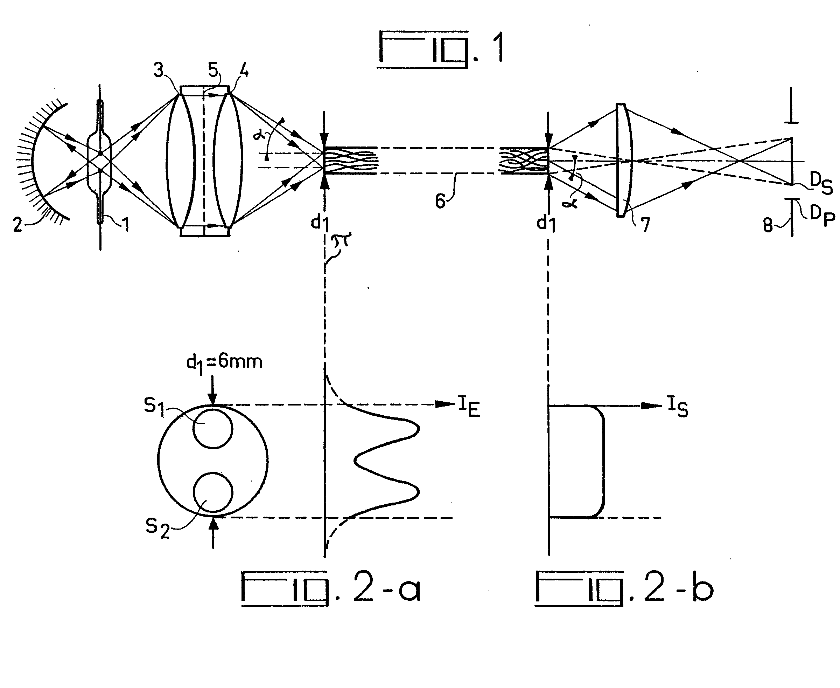

Sur la figure 1 a été représenté un illuminateur comportant une lampe à arc à vapeur de mercure, tel que ceux utilisés actuellement, dans lequel le degré de cohérence $\sigma$ a été choisi égal à 0.7. Il comporte la lampe à vapeur de mercure 1. Une telle lampe a deux points chauds entre lesquels s'établit l'arc et le rayonnement lumineux issu d'une telle lampe semble provenir pour la plus grande partie de ces deux points formant en quelque sorte "points sources". Un miroir 2, permet de renvoyer vers le dispositif optique une partie du rayonnement émis vers l'arrière du dispositif. L'illuminateur comporte en outre un condenseur formé de deux lentilles 3 et 4 et un système de filtres 5 permettant de sélectionner parmi les différentes raies du spectre d'émission du mercure une ou plusieurs raies de longueurs d'ondes utilisables pour le transfert optique de motifs. Cet ensemble condenseur-filtres permet de former dans un plan image $\pi$

une image de la source 1. La répartition d'éclairement dans ce plan image est semblable à celle du plan source. Cette répartition est représentée sur la figure 2a). Ce rayonnement est ensuite capté par un faisceau de fibres optiques mélangées 6, de façon que dans la face de sortie du faisceau 6, la répartition d'éclairement soit quasi-uniforme comme représenté sur la figure 2b). Le faisceau de fibres capte à l'entrée le rayonnement sous une incidence n'excèdant pas $\alpha$, $\alpha$ étant l'angle d'ouverture de la fibre, et restitue à la sortie le rayonnement sous les mêmes incidences (n'excèdant pas $\alpha$). Cette ouverture $\alpha$ est choisie en fonction de l'ouverture numérique et du diamètre de l'objectif utilisé, et du diamètre de la face de sortie du faisceau pour qu'il y ait conservation du flux lumineux.

La face de sortie du faisceau de fibres 6 est imagée à travers la lentille 7 sur la pupille d'entrée 8 de l'objectif de projection (non représenté). A titre d'exemple, pour une lampe de 350 W, la source a ses deux points chauds distants de 3,8 mm, ces points étant les centres de zones lumineuses $S_1$ et $S_2$ de 2 mm de diamètre environ. Compte tenu de ces caractéristiques, un faisceau de fibres optiques de diamètre $d_1=6$ mm permet de capter la plus grande partie du rayonnement émis. Le diamètre de la source effective formée par la face de sortie du faisceau 6 est donc $d_1=6$ mm. La lentille de sortie 7 de l'illuminateur est telle qu'elle forme sur la pupille d'entrée 8 une image de cette face de sortie telle que son diamètre $D_s$ soit dans le rapport $\sigma=0.7$ avec le diamètre $D_p$ de la pupille d'entrée. L'ouverture correspondante, avec un objectif d'ouverture numérique 0.3 et de diamètre 15 mm, est 30°.

La figure 3 représente l'illuminateur selon l'invention. Dans cet illuminateur, les éléments semblables à ceux de l'illuminateur représenté sur la figure 1 ont été désignés par les mêmes repères. L'ensemble formé par la lampe à vapeur de mercure 1, le miroire 2, l'ensemble condenseur 3, 4 associé aux filtres 5 est inchangé et forme dans un plan image $\pi$ de la source 1 une répartition d'éclairement semblable à celle fournie par la source. Pour augmenter la cohérence, le diamètre $d_3$ de la source effective dans le plan source pour le dispositif optique de projection, c'est à dire la face de sortie du faisceau 10, est réduit dans un rapport tel que cette source effective est imagée dans le plan S de la pupille 8 sous forme d'une source lumineuse dont le diamètre $D'_s$ est dans le rapport $\sigma=0.3$ avec le diamètre $D_p$ de la pupille d'entrée. Pour cela, au lieu de réduire la taille de la source effective au moyen d'un diaphragm bloquant une fraction du rayonnement émis par la face de sortie du faisceau de fibres optiques assurant le mélange du rayonnement (cette solution correspond à une diminution du rendement énergétique dans le même rapport que la diminution des surfaces de sources utiles), l'illuminateur selon l'invention comporte un faisceau de fibres optiques 10 dont la face de sortie a un diamètre $d_3$ tel que l'image formée par une lentille de sortie 7 sur la pupille d'entrée 8 du dispositif de projection donne à l'illumination un degré de cohérence déterminé, ce faisceau de fibres 10 étant divisé dans la face d'entrée en deux faisceaux 11 et 12 dont les axes sont alignés avec les points d'éclairement maximum dans le plan image $\pi$ de la source par le condenseur. Ce faisceau 10 comporte donc deux extrémités 11 et 12 de diamètres égaux à $d_2$, dont les axes longitudinaux sont alignés avec les points source formés dans le plan image $\pi$. Ce diamètre $d_2$ est fixé de telle manière que le diamètre $d_3$ du faisceau à la sortie correspondant à la réunion de toutes les fibres du faisceau mélangées, soit $d_3=\sqrt{2}d_2$, donne par imagerie à travers la lentille condenseur 7 une source effective, dans le plan de la pupille d'entrée 8, dont le diamètre D'S est dans le rapport $\sigma$ avec le diamètre DP de cette pupille elle-même. Une telle structure permet dans tous les cas, et particulièrement dans le cas où $\sigma=0.3$, considéré comme optimale eu égards aux autres caractéristiques du dispositif, d'avoir un rendement lumineux aussi grand que possible puisque la source effective pour le système de projection est formée à partir des zones les plus lumineuses de la source. Ainsi, pour un rendement énergétique donné pour $\sigma=0.7$ avec l'illuminateur de la figure 1, la solution simple qui consiste à diaphragmer pour obtenir $\sigma=0.3$ conduit à une perte de 80% d'énergie lumineuse. Au contraire, le dispositif selon l'invention ne conduit qu'à une perte de 40% d'énergie lumineuse, cette perte étant largement compensée par des gains obtenus par l'augmentation de la cohérence.

Pour que les extrémités des deux demi-faisceaux 11 et 12 dans le plan image $\pi$ de la source soient bien positionnées par rapport aux points d'éclairement maximum dans ce plan, il est possible de lier mécaniquement de manière définitive la lampe à décharge 1, l'ensemble condenseur-filtres (3, 4, 5) et les extrémités des deux demi-faisceaux comme cela a été représenté schématiquement sur la figure 3.

Mais il est également possible de commander des microdéplacements des extrémités 11 et 12 des demi-faisceaux dans ce plan $\pi$ en détectant à l'aide d'un composant opto-électronique $D_1$ (par exemple une photodiode) une petite partie du rayonnement émergeant du faisceau 10 par une boucle d'asservissement de position SV, les déplacements étant tels que ce rayonnement soit toujours maximum.

L'invention n'est pas limitée au mode de réalisation de l'invention précisément décrit en référence à la figure 3. En particulier, l'illuminateur pourrait comporter une lampe à arc à décharge utilisant un autre gaz que la vapeur de mercure. Pour que l'illuminateur puisse avoir la structure décrite, il suffit seulement que l'on puisse déterminer dans un plan image de la source des points d'éclairement maximum sur lesquels seront alignées deux extrémités séparées d'un faisceau de fibres mélangées. De plus, la description du mode de réalisation particulière de la figure 3 indique qu'un degré de cohérence $\sigma=0.3$ à été choisi car cette valeur correspond à une bonne résolution effective et ne conduit pas à trop de défauts liés à un trop grand degré de cohérence. Il est cependant facile de choisir les caractéristiques du faisceau de fibres optiques en fonction de celles de l'illuminateur pour obtenir un autre degré de cohérence en maximisant le rendement énergétique comme décrit ci-dessus.

Enfin, la description du mode de réalisation particulier de la figure 3 indique que les deux extrémités séparées du faisceau dans le plan image de la source ont des sections circulaires et de diamètres égaux. Cette disposition est intéressante lorsque les deux zones lumineuses $S_1$ et $S_2$ formés par la lampe à arc sont circulaires et de même diamètre. En pratique, ces deux zones sont fonction de la forme des électrodes et peuvent être oblongues. Dans ce cas les fibres pourront être arrangées dans les extrémités placées dans le plan image de la source pour que les sections correspondent au mieux aux taches lumineuses formées. Ces taches peuvent d'ailleurs avoir des surfaces différentes.

De la même manière, la section du faisceau de sortie peut être adaptée au dispositif d'utilisation.

**Revendications**

1. Illuminateur comportant une lampe à arc (1) servant de source, un assemblage de lentilles condenseur (3, 4) et de filtres (5) formant dans un plan image ($\pi$) de la source (1) une image réelle de la source à partir du rayonnement issu de la lampe à arc (1) cette image comportant deux zones d'intensité maximum, un faisceau de fibres optiques (10) dont la face d'entrée est placée dans le plan image ($\pi$) pour capter le rayonnement dans celui-ci, et dont la face de sortie formant source pour une lentille intermédiaire (7) présente une surface telle que son image par cette lentille intermédiaire donne lieu, pour un dispositif d'utilisation optique déterminé, à une illumination présentant un degré de cohérence spatiale ($\sigma$) donné au niveau de la pupille d'entrée dudit dispositif d'utilisation optique; la surface totale de la face d'entrée du faisceau de fibres optiques étant sensiblement égale à la surface de sa face de sortie, caractérisé en ce que ledit degré de cohérence spatiale est désiré tel qu'il nécessite le choix, pour la face de sortie du faisceau de fibres optiques (10), d'une surface inférieure à celle de l'image réelle de ladite source (1) dans le plan image ($\pi$) de celle-ci, les fibres optiques du faisceau (10) étant alors assemblées dans la face d'entrée placée dans le plan image ($\pi$) en deux faisceaux séparés (11, 12) dont les extrémités sont alignés avec les deux zones d'intensité maximum dans le plan image (π) de la source (1), de façon à capter le maximum du rayonnement dans ce plan image (π).

2. Illuminateur selon la revendication 1, caractérisé en ce que le faisceau de fibres (10) comporte des fibres mélangées (13) de façon que le rayonnement dans la face de sortie du faisceau soit réparti de manière quasi uniforme.

3. Illuminateur selon l'une quelconque des revendications 1 et 2, caractérisé en ce que la lampe à arc (1) est une lampe à décharge à vapeur de mercure.

4. Illuminateur selon l'une quelconque des revendications précédentes, caractérisé en· ce que les positions des extrémités des deux faisceaux séparés (11, 12) sont adjustées de manière définitive, ces deux extrémités étant mécaniquement liées à la lampe à décharge (1).

5. Illuminateur selon l'une quelconque des revendications 1 à 3, caractérisé en ce que, pour ajuster à tout instant les positions des extrémités des deux faisceaux séparés (11, 12) dans le plan image (π) de la source (1) l'illuminateur comporte des moyens d'asservissement (SV) de position de ces deux extrémités tel que le rayonnement émergeant soit toujours maximum.

**Patentansprüche**

1. Beleuchtungseinrichtung mit einer als Quelle dienenden Bogenlampe (1), einer Gruppe von Kondensatorlinsen (3, 4) und Filtern (5), die in einer Bildebene (π) der Quelle (1) ein reelles Bild der Quelle aus der von der Bogenlampe (1) ausgehenden Strahlung erzeugt, wobei dieses Bild zwei Zonen maximaler Intensität aufweist, mit einem Lichtleitfaserbündel (10), dessen Eintrittsfläche in der Bildebene (π) angeordnet ist, um die Strahlung in dieser aufzunehmen, und dessen Austrittsfläche eine Quelle für eine Zwischenlinse (7) bildet und eine solche Oberfläche aufweist, daß ihre durch diese Zwischenlinse erzeugte Abbildung für eine bestimmte optische Anwendungsvorrichtung zu einer Beleuchtung führt, die einen gegebenen Grad räumlicher Kohärenz (σ) an der Eintrittspupille der optischen Anwendungsvorrichtung aufweist; wobei die Gesamtoberfläche der Eintrittsfläche des Lichtleitfaserbündels im wesentlichen gleich der Oberfläche seiner Austrittsfläche ist, dadurch gekennzeichnet, daß der genannte Grad räumlicher Kohärenz derart gewünscht ist, daß er für die Austrittsfläche des Lichtleitfaserbündels (10) die Wahl einer Oberfläche erfordert, die kleiner als die des reellen Bildes der genannten Quelle (1) in der Bildebene (π) derselben ist, wobei die Lichtleitfasern des Bündels (10) in der in der Bildebene (π) liegenden Eintrittsfläche zu zwei getrennten Bündeln (11, 12) zusammengesetzt sind, deren Enden nach den zwei Zonen maximaler Intensität in der Bildebene (π) der Quelle (1) ausgerichtet sind, so daß sie das Maximum der Strahlung in dieser Bildebene (π) aufnehmen.

2. Beleuchtungseinrichtung nach Anspruch 1, dadurch gekennzeichnet, daß das Faserbündel (10) derart gemischte Fasern (13) enthält, daß die Strahlung in der Austrittsfläche des Bündels praktisch gleichförmig verteilt ist.

3. Beleuchtungseinrichtung nach Anspruch 1 oder 2, dadurch gekennzeichnet, daß die Bogenlampe (1) eine Quecksilberdampf-Entladungslampe ist.

4. Beleuchtungseinrichtung nach einem der vorstehenden Ansprüche, dadurch gekennzeichnet, daß die Lagen der Enden der zwei getrennten Bündel (11, 12) in endgültiger Form justiert sind, wobei diese zwei Enden mechanisch mit der Entladungslampe (1) verbunden sind.

5. Beleuchtungseinrichtung nach einem der Ansprüche 1 bis 3, dadurch gekennzeichnet, daß zum jederzeitigen Justieren der Lagen der Enden der zwei getrennten Bündel (11, 12) in der Bildebene (π) der Quelle (1) die Beleuchtungseinrichtung Positionsnachführungsmittel (SV) zur deratigen Nachführung dieser beiden Enden umfaßt, daß die austretende Strahlung stets maximal ist.

**Claims**

1. Illuminator comprising an arc lamp (1) used as the source, an assembly of condenser lenses (3, 4) and of filters (5) forming in an image plane (π) of the source (1) a real image of the source from the radiation issuing from the arc lamp (1), this image comprising two zones of maximum intensity, an optical fiber bundle (10) the input face of which is disposed in the image plane (π) for receiving the radiation therefrom, and the output face of which forms a source of an intermediate lens (7) and has a surface such that its image formed by said intermediate lens causes an illumination for a determined optical application having a given degree of spatial coherence (σ) at the level of the input aperture of said optical application device; the total surface of the input face of the optical fiber bundle being substantially equal to the surface of its output face, characterized in that said degree of spatial coherence is desired in such a manner that it requires the selection for the output face of the optical fiber bundle (10) of a surface smaller than that of the real image of said source (1) within the image plane (π) thereof, the optical fibers of the bundle (10) being assembled at the input face disposed within the image plane (π) in two separate bundles (11, 12) the ends of which are aligned with the two zones of maximum intensity within the image plane (π) of the source (1), in a manner to capture the maximum of radiation within this image plane (π).

2. Illuminator according to claim 1, characterized in that the fiber bundle (10) comprises fibers (13) mixed in such a manner that the radiation within the output face of the bundle is distributed in practically uniform manner.

3. Illuminator according to any of claims 1 and 2, characterized in that the arc lamp (1) is a mercury vapor discharge lamp.

4. Illuminator according to any of the preceding claims, characterized in that the positions of the ends of the two separate bundles (11, 12) are adjusted in a final manner, these two ends being mechanically connected to the discharge lamp (1).

5. Illuminator according to any of claims 1 to 3, characterized in that, for adjusting the positions of the ends of the two separate bundles (11, 12) within the image plane ($\pi$) of the source (1) at any time, the illuminator comprises controlled follow-up means (SV) for readjusting the positions of these two ends in such a manner that the emergent radiation is always maximum.

Fig. 1

Fig. 2-a

Fig. 2-b

$d_1 = 6mm$

0 018 264

FIG.3

FIG.4-a

FIG.4-b

0018264